# EUROPÄISCHE PATENTSCHRIFT

(11) **EP 2 446 484 B1**
(45) Veröffentlichungstag und Bekanntmachung des Hinweises auf die Patenterteilung: **29.05.2013**
(21) Anmeldenummer: 10724871.8
(22) Anmeldetag: 21.06.2010
(51) Int. Cl.: H01L 31/108, H01L 31/18

(54) **TRANSPARENTE GLEICHRICHTENDE METALL-METALLOXID-HALBLEITERKONTAKTSTRUKTUR UND VERFAHREN ZU IHRER HERSTELLUNG UND VERWENDUNG**
TRANSPARENT RECTIFYING METAL/METAL OXIDE/SEMICONDUCTOR CONTACT STRUCTURE AND METHOD FOR THE PRODUCTION THEREOF AND USE
STRUCTURE DE CONTACT À SEMI-CONDUCTEURS MÉTAL-OXYDE MÉTALLIQUE DE REDRESSEMENT TRANSPARENTE, PROCÉDÉ DE FABRICATION ET UTILISATION DE LADITE STRUCTURE DE CONTACT

(30) Priorität: 22.06.2009 DE 102009030045
(43) Veröffentlichungstag der Anmeldung: 02.05.2012
(73) Patentinhaber: Universität Leipzig, 04109 Leipzig (DE)
(72) Erfinder: GRUNDMANN, Marius, 04105 Leipzig (DE); FRENZEL, Heiko, 04318 Leipzig (DE); LAJN, Alexander, 04275 Leipzig (DE); VON WENCKSTERN, Holger, 04275 Leipzig (DE)
(74) Vertreter: Stötter, Gerd
(86) Internationale Anmeldenummer: PCT/EP2010/058726
(87) Internationale Veröffentlichungsnummer: WO 2010/149616

(56) Entgegenhaltungen:
- LIN YOW-JON: "Hole-transport barrier and band bending at the indium tin oxide/polymer/p-AlGaN interface" APPLIED PHYSICS LETTERS, AIP, AMERICAN INSTITUTE OF PHYSICS, MELVILLE, NY, US LNKD- DOI:10.1063/1.2362597, Bd. 89, Nr. 15, 13. Oktober 2006 (2006-10-13), Seiten 152121-152121, XP012086299 ISSN: 0003-6951
- WAGER ET AL: "Transparent electronics: Schottky barrier and heterojunction considerations" THIN SOLID FILMS, ELSEVIER-SEQUOIA S.A. LAUSANNE, CH LNKD- DOI:10.1016/J.TSF.2007.06.164, Bd. 516, Nr. 8, 1. Februar 2008 (2008-02-01), Seiten 1755-1764, XP022449711 ISSN: 0040-6090
- YOON JONG-GUL ET AL: "Characteristics of indium-tin-oxide Schottky contacts to ZnMgO/ZnO heterojunctions with band gap grading" APPLIED PHYSICS LETTERS, AIP, AMERICAN INSTITUTE OF PHYSICS, MELVILLE, NY, US LNKD- DOI:10.1063/1.3268787, Bd. 95, Nr. 22, 1. Dezember 2009 (2009-12-01), Seiten 222102-222102, XP012126633 ISSN: 0003-6951

## Beschreibung

Es wird eine Kontaktstruktur vorgeschlagen, die bevorzugt als transparentes Schichtsystem ausgeführt ist und gleichrichtende Eigenschaften aufweist. Weiterhin wird ein Verfahren zur Schaffung einer derartigen Kontaktstruktur dargestellt sowie Möglichkeiten zu ihrer Verwendung aufgezeigt. Die Kontaktstruktur besteht dabei mindestens aus einem vorzugsweise transparenten Halbleiter, einem transparenten Metalloxid und einem transparenten elektrischen Leiter.

Aus dem Stand der Technik sind mehrlagige Kontaktstrukturen bekannt, die isolierende oder leitende Eigenschaften haben. Bei den isolierenden Kontaktstrukturen werden dabei aus der Silizium-Industrie bekannte Metall-Isolator-Halbleiter-Übergänge (MIS) oder spezieller: MetallOxid-Halbleiter-Übergänge (MOS) realisiert. Diese werden zur Herstellung von MIS-Dioden (z. B. zur Detektion von elektromagnetischer Strahlung) und MOS-Feldeffekttransistoren (MOSFETs) verwendet.

Im Bereich der leitfähigen Kontakte gibt es zum einen ohmsche Kontakte aus transparenten ohmsch leitfähigen Oxiden (Transparent Conductive Oxides, TCO) und zum anderen nicht transparente Metallkontakte (ohmsch oder gleichrichtend). Das Dokument Lin Yow-Jon, Applied Physics Letters, AIP, vol. 89, n.15, p. 152121-152121 (2006) beschreibt eine transparente gleichrichtende kontaktstruktur.

Die DE 199 51 207 A1 beschreibt ein Halbleiterbauelement zur Detektion elektromagnetischer Strahlung. Es soll insbesondere UV-Strahlung gemessen werden, während die Messungen nicht durch sichtbares Licht verfälscht werden sollen. Aus diesem Grunde kommt ein im sichtbaren Wellenlängenbereich transparenter Schichtaufbau zum Einsatz. Auf einem Glassubstrat wird eine Kontaktschicht aus einem transparenten metallisch leitenden Oxid (TCO), hier Fluor-dotiertes Zinnoxid, oder einem Metall angeordnet. Darüber folgt eine Schicht eines Metalloxid-Verbindungshalbleiters, in der die einfallende UV-Strahlung absorbiert werden soll. Als oberste Lage folgt eine Metallschicht, die mit der darunterliegenden Halbleiterschicht einen Schottky-Kontakt ausbildet. Die Metallschicht soll dabei bis zu 20 nm dick sein, um ihre Transparenz zu gewährleisten. Durch die Metallschicht dringen 20 - 30 % der UV-Strahlung.

Die US 7,341,932 B2 offenbart den Aufbau einer Diode mit einer Schottky-Barriere, die zur Detektion von UV-Strahlung (Wellenlänge < 200 nm) unter Ausblendung des sichtbaren Lichts geeignet sein soll. Die Schottky-Barriere bildet sich an einer Grenzschicht am Übergang von einer Pt-Schicht zu n⁻-dotiertem GaN aus. Das aktive Gebiet der Diode erreicht Abmessungen von 0,25 cm² bis 1 cm^{2.}

Die US 7,285,857 B2 offenbart den Aufbau einer transparenten, ohmsch leitfähigen Elektrode für Solarzellen. Die Solarzellen bestehen dabei aus GaN. Der Elektrodenaufbau sieht eine transparente Struktur aus Zn-basiertem Material mit einer Deckschicht aus einem dünn aufgebrachten Metall oder einem transparenten leitfähigen Oxid vor.

Die WO 2008/143526 A1 beschreibt gleichrichtende und ohmsche Kontakte, die Metalloxide oder Metalle auf Zinkoxid-Substraten aufweisen. Die gleichrichtenden Kontakte werden erzeugt, indem eine leitfähige Schicht auf dem Zinkoxid aufgebracht wird und sich zwischen den Schichten eine gleichrichtende Grenzschicht ausbildet. Die Mechanismen entsprechen den von Metall-Halbleiterschichtungen bekanten Schottky-Kontakten. Die offenbarten Kontaktstrukturen sind jedoch nicht transparent.

In der WO 01/15241 A1 wird ein Sensor für UV-Strahlen vorgestellt. Dabei ist auf einem Substrat eine optische Absorptionsschicht angeordnet, auf der mittels einer weiteren Schicht ein Schottky-Kontakt ausgebildet wird. Der Schottky-Kontakt wird mit einer Schicht eines leitfähigen Oxids (ITO) bedeckt. Der Sensor weist darüber hinaus zwei ohmsche Kontakte auf, die getrennt von dem Schottky-Kontakt angeordnet sind. Als transparenter Halbleiter kommt ein Metallnitrid (GaN) zum Einsatz.

Gegenstand der US 2007/0206651 A1 ist eine Leuchtdiode, die auf einem Substrat eine Aktive Schicht zwischen zwei Begrenzungsschichten aufweist, wobei auf der oberen Begrenzungsschicht eine Kontaktstruktur aus Indiumgalliumnitrid angeordnet ist, deren Bandlücke schichtweise abnimmt und am geringsten auf dessen Oberseite ist, wo sie von einer transparenten Elektrode bedeckt wird. Da die US 2007/0206651 A1 eine LED beschreibt, handelt es sich notwendigerweise um eine Schichtstruktur aus einer p-leitenden und einer n-leitenden Halbleiterschicht. Daher wird bei diesem bipolaren Bauelement die Gleichrichtung durch den p-n-Übergang bewirkt und nicht durch eine Gleichrichtung an einer Grenzfläche von Metalloxid und Halbleiter.

Es stellt sich somit die Aufgabe, den Aufbau und ein Verfahren zur Herstellung einer transparenten gleichrichtenden Kontaktstruktur zu finden. Weiterhin sollen Anwendungsmöglichkeiten für die transparente gleichrichtende Schichtstruktur aufgezeigt werden.

Unter "transparent" wird im Weiteren ein Lichtdurchgang durch das Schichtsystem von mindestens 50 %, vorzugsweise 75 % oder mehr, des eingestrahlten Lichtstroms im betrachteten Spektralbereich verstanden. Der betrachtete Spektralbereich umfasst vorzugsweise das sichtbare

Licht in einem Wellenlängenbereich von 380 - 780 nm.

Erfindungsgemäß wird die Aufgabe entsprechend dem Anspruch 1 gelöst. Die Verwendung einer transparenten gleichrichtenden Kontaktstruktur in Applikationen der Sensorik ist Gegenstand des nebengeordneten Anspruchs 3. Ein Verfahren zur Herstellung einer transparenten gleichrichtenden Kontaktstruktur wird im unabhängigen Anspruch 12 offenbart. Möglichkeiten zur Verwendung der transparenten gleichrichtenden Kontaktstruktur werden im unabhängigen Anspruch 17 offenbart. Vorteilhafte Ausführungsformen sind in den rückbezogenen Unteransprüchen dargestellt.

Bestimmend für die Transparenz eines Halbleiters oder Metalloxids ist die Bandlücke, die Leitungs- und Valenzband trennt, bzw. die mit dem Absorptionskoeffizienten verbundene Schichtdicke. Zur Herstellung von Halbleitern, die auch im sichtbaren Bereich transparent sind, kommen daher Galliumnitrid, Zinkoxid und andere Nitrid- bzw. Oxid-Verbindungen zum Einsatz. Hier sind insbesondere Indiumzinnoxid (Indium Tin Oxide, ITO), Fluorzinnoxid (Fluor Tin Oxide, FTO), Aluminiumzinkoxid (Aluminium Zinc Oxide, AZO) und Antimonzinnoxid (Antimony Tin Oxide, ATO) zu nennen.

Die Erfindung offenbart eine gleichrichtende Kontaktstruktur, die bevorzugt transparent ist und
a) einen Halbleiter, der bevorzugt transparent ist und bevorzugt als Halbleiterschicht ausgebildet ist,
b) eine Schicht transparenten Metalloxids, transparenten Metallnitrids oder transparenten Metallsulfids und
c) eine Schicht eines transparenten elektrischen Leiters
in der oben genannten Reihenfolge aufweist.

Die Bestandteile a) bis c) bilden gemeinsam ein Schichtsystem, das bevorzugt so ausgebildet ist, dass die Schicht c) nicht mit dem Halbleiter a) in Kontakt kommt.

Um die Transparenz des Schichtsystems zu gewährleisten, kommen vorteilhaft Halbleiter a) mit einer großen Bandlücke, z. B. ZnO, GaN oder weitere transparente Halbleiter wie Diamant, AIN, ZnMgO, CuAlO₂, AllnN, ZnS, ZnSe, AlGaN, ZnCdO, Ga₂O₃, In₂O₃ oder InGaN zum Einsatz. Auch organische Halbleiter können genutzt werden. Wenn auf eine Transparenz im gesamten sichtbaren Spektralbereich (380-780nm) verzichtet werden kann, z. B. für Anwendungen im infraroten Spektralbereich, sind auch andere Halbleiter, wie z. B. Si, Ge, GaAs, InP, GaP, etc. möglich.

Der Halbleiter kann als Volumenmaterial, als dünne Schicht oder als Nanostruktur ausgebildet sein.

Auf den Halbleiter a) wird eine Metalloxidschicht b) aufgebracht. Um die Transparenz der Metalloxidschicht zu gewährleisten, muss diese hinreichend dünn sein. Derartig dünne Metalloxidschichten weisen jedoch eine geringe laterale Leitfähigkeit auf. Um eine homogene Injektion von Ladungsträgern bzw. eine gleiche elektrische Spannung über die Fläche der Kontaktstruktur zu ermöglichen, wird daher eine transparente elektrisch leitfähige Schicht auf der Metalloxidschicht aufgebracht. Dieser transparente elektrische Leiter bildet bevorzugt die oberste Schicht des Schichtsystems. Als Material kommen dabei dünne und dadurch ebenfalls transparente Metalle zum Einsatz oder es wird ein hochleitfähiges transparentes Oxid (z. B. AZO, ITO, FTO, ATO usw.) verwendet.

In der genannten Kombination ist das Schichtsystem transparent für einen anwendungsspezifischen Spektralbereich und weist gleichzeitig eine hohe Gleichrichtung auf. Die hohe Gleichrichtung wird durch Verwendung nicht isolierender und nicht leitender Metalloxide erreicht (deren spezifischer Widerstand zwischen dem der leitenden und der nicht leitenden Materialien liegt), die gegenüber herkömmlich verwendeten reinen Metallen eine höhere Austrittsarbeit aufweisen.

Bevorzugt ist mindestens einer der genannten Bestandteile
a) transparenter Halbleiter,
b) transparentes Metalloxid , transparentes Metallnitrid oder transparentes Metallsulfid und
c) transparenter elektrischer Leiter
seinerseits wieder aus Schichten aufgebaut.

Der Halbleiter a) ist vorzugsweise beliebig dotiert, mit anderen Elementen oder Verbindungen gemischt oder legiert.

Bevorzugt wird der Halbleiter (Bestandteil a)) auf einem Substrat aufgebracht und die Kontaktstruktur davon ausgehend weiter aufgebaut. Alternativ ist der Halbleiter ein Volumenmaterial und bildet selbst das Substrat für den weiteren Schichtaufbau. Das Substrat kann vorteilhaft selbst transparent und/oder flexibel sein. Die Krümmungsradien eines flexiblen Substrats erreichen bevorzugt mehr als 2 cm, weiter bevorzugt 0,5 cm und besonders bevorzugt 1 mm oder weniger. Als geeignete Materialien für das Substrat kommen beispielsweise Kunststoffe, Glas, Saphir, Silizium, SiO₂, ZnO, GaN zum Einsatz.

Der Halbleiter a) ist vorteilhaft ebenfalls als Heterostruktur ausgebildet. So ist es möglich, dass der Halbleiter aus einer Abfolge von dünnen Schichten unterschiedlicher Materialien besteht, die sich gegebenenfalls periodisch wiederholt. Dabei werden vorteilhaft auch verschiedene Halbleiter in der Schichtfolge eingesetzt. Die Ladungsträgerdichte im Halbleiter liegt bevorzugt im Bereich von 10¹² bis 10¹⁹ cm⁻³ und besonders bevorzugt im Bereich von 10¹⁴ bis 10¹⁸ cm⁻³.

Das Material der Schicht b) weist vorteilhaft eine hohe Austrittsarbeit auf. So können z. B. die Oxide, Nitride und Sulfide von Ag, Pt, Ir, Cu, Pd, Cr, Ni und anderen Metallen zum Einsatz kommen. Bevorzugt wird das Metalloxid durch ein Metallnitrid oder Metallsulfid ersetzt. Die Schicht b) ist bevorzugt dünner als 30 nm, besonders bevorzugt dünner als 20 nm und weiterhin bevorzugt dünner als 10 nm, um die Transparenz zu gewährleisten. Das Material der Schicht b) ist nicht isolierend. Die Leitfähigkeit der Schicht b) wird verbessert, wenn das Metalloxid, Metallnitrid oder Metallsulfid mit geeigneten Stoffen gemischt oder dotiert wird. Die spezifischen Widerstände der Schicht b) liegen vorzugsweise im Bereich von 10² Ωcm bis 10⁷ Ωcm. Das Material der Schicht b) ist somit auch nicht leitend, sondern sein spezifischer Widerstand liegt im Bereich zwischen dem der leitenden und der isolierenden Materialien.

Auch eine Schichtung aus verschiedenen Metalloxiden, Metallnitriden oder Metallsulfiden ist möglich. Bevorzugt enthält das Metalloxid, Metallnitrid oder Metallsulfid mehr Metallatome als durch das stöchiometrische Verhältnis vorgegeben ist.

Die Schicht des transparenten elektrischen Leiters (Schicht c)) weist vorteilhaft eine dünne transparente metallische Schicht (z. B. Au, Ag, Pt) oder ein geeignetes transparentes leitfähiges Oxid (TCO: beispielsweise ITO, FTO, AZO und ATO) auf. Die Schicht des transparenten elektrischen Leiters bildet vorzugsweise die oberste Schicht der Kontaktstruktur. Die Schicht c) ist bevorzugt chemisch stabil. Wenn es sich bei der Schicht des transparenten elektrischen Leiters um ein Metall handelt, ist diese Schicht dünn genug, um transparent zu sein. Als vorteilhaft hat sich eine maximale Dicke von 20 nm erwiesen, wobei diese vom eingesetzten Metall abhängig ist. Die spezifischen Widerstände der Schicht c) liegen bevorzugt im Bereich von 10⁻⁴Ωcm bis 10-⁵ Ωcm und weiter bevorzugt im Bereich von 1 Ωcm bis 10⁻⁶ Ωcm.

Die transparente metallische Schicht kann dotiert sein und/oder ein Stoffgemisch enthalten und/oder aus mehreren Schichten bestehen. Wenn der transparente elektrische Leiter ein leitfähiges Metalloxid (TCO) aufweist, kann dieses mehr Metallatome enthalten, als durch das stöchiometrische Verhältnis vorgegeben ist. Vorteilhaft kann die Schicht des transparenten elektrischen Leiters auch ein organisches leitfähiges Material wie z. B. PEDOT:pss (Poly(3,4-ethylenedioxythiophene) poly(styrenesulfonate))aufweisen. Vorteilhaft bedeckt die Schicht c) die Schicht b) nicht vollständig, um Kantenströme zwischen der Schicht c) und dem Halbleiter a) zu vermeiden. Die Schicht c) bedeckt die Schicht b) bevorzugt zu 90 % bis unter 100 %, weiter bevorzugt 95 % bis 98 %.

Bevorzugt wird auf der transparenten Schicht c) eine Deckschicht als Zusatzschicht aufgebracht. Vorteilhaft wird der Lichteintritt in die transparente gleichrichtende Kontaktstruktur verbessert, indem die Deckschicht antireflexive Eigenschaften aufweist, die den Lichteintritt in das Schichtsystem erleichtern. Diese Deckschicht weist eine Dicke von mindestens 3 nm auf. Die Deckschicht bedeckt vorteilhaft nicht nur die transparente Kontaktstruktur sondern kann sich über das gesamte Bauelement, in dem die transparente Kontaktstruktur ausgebildet ist, oder über Bereiche der Halbleiterstruktur, zu der die transparente Kontaktstruktur gehört, erstrecken, wobei eventuelle Anschlüsse oder Bondkontakte ausgeschlossen sein können. Die Deckschicht kann ihrerseits wiederum dotiert sein und/oder ein Stoffgemisch enthalten, legiert und/oder mehrlagig sein. Die Deckschicht erstreckt sich vorteilhaft nicht nur auf der Oberseite der transparenten Kontaktstruktur sondern auch an deren Seiten, so dass sie die Kanten der darunterliegenden Schichten und/oder Bereiche des Bauteils, zu dem die transparente gleichrichtende Kontaktstruktur gehört, ebenfalls bedeckt. Die Deckschicht wirkt passivierend und ist damit elektrisch nichtleitend (Isolator). Der spezifische Widerstand der Deckschicht liegt bevorzugt bei mindestens 10¹⁰ Ωcm und besonders bevorzugt bei ca. 10¹² Ωcm und höher. Vorteilhaft ist die Verwendung von Dielektrika wie: HfO₂, Al₂O₃, ZrO₂, SiOₓ, Si₃N₄, und anderen. Es eignen sich aber auch organische Deckschichten wie z. B. PMMA oder Epoxidharze, oder deren Gemische mit Dielektrika. Die Deckschicht wirkt vorzugsweise auch chemisch passivierend, so dass sie darunterliegende Schichten gegen chemische Veränderungen schützt. Zur Herstellung der Deckschicht kommen etablierte Depositionsverfahren wie Kathodenzerstäubung (Sputtern), spin coating, dip coating, Atomlagenabscheidung (ALD), gepulste Laserdeposition (PLD) und andere zum Einsatz. Die Deckschicht reduziert, wenn sie in einem Bauelement zum Einsatz kommt, in dem z. B. Transistorstrukturen ausgebildet sind, zum einen Leckströme insbesondere entlang der Bauteiloberfläche zwischen Source und Drain. Zum anderen werden bei einem Einsatz in einer transparenten Kontaktstruktur Ströme entlang des Randes der Metalloxidschicht zwischen der transparenten metallischen Schicht und dem darunterliegenden Halbleiter unterdrückt. Dies reduziert den off-Strom (Strom der im ausgeschalteten Zustand eines Bauelementes weiterhin fliest) und damit die Leistungsaufnahme des Bauelements im off-Zustand (Ausschalt-Zustand). Die Reduktion des off-Stroms erhöht zudem die Dynamik des Bauelements (Verhältnis zwischen on- und off-Strom, on-Zustand ist der eingeschaltete Zustand, on-Strom ist der Strom im eingeschalteten Zustand).

Zur Herstellung der transparenten gleichrichtenden Kontaktstruktur wird ein Halbleiterkristall oder eine Halbleiterschicht bevorzugt geeignet dotiert. Als Halbleiter kommt für transparente Kontaktstrukturen mit Lichtdurchlässigkeit im sichtbaren Bereich insbesondere ZnO mit geeigneter Dotierung (z. B. Al) in Frage. Der Halbleiter wird nachfolgend mittels bekannter Verfahren (z. B. Nass- oder Trockenätzen) strukturiert oder geeignete Strukturen werden auf der Halbleiteroberfläche oder der Oberfläche eines Substrates aufgewachsen und diese anschließend dotiert. Gegebenenfalls wird der Halbleiter noch einer Reinigung, z. B. mittels Plasma unterzogen. Auf die entsprechenden Strukturen des Halbleiter a) wird eine transparente Schicht b) aus Metalloxid, Metallsulfid oder Metallnitrid aufgebracht. Dies geschieht z. B. durch reaktives oder nichtreaktives Sputtern (DC, AC, Magnetron), gepulste Laserdeposition (PLD), Molekularstrahlepitaxie (MBE), Atomlagenabscheidung (ALD), chemische Gasphasenabscheidung (CVD/PECVD), metallorganische Gasphasenepitaxie (MOVPE) oder entsprechende aus dem Stand der Technik bekannte Verfahren. Vorteilhaft wird dazu eine Metallschicht aufgebracht und diese dann gezielt oxidiert. Bevorzugt wird die Schicht b) aus mehreren Lagen eines oder unterschiedlicher Metalloxide, Metallsulfide oder Metallnitride durch aufeinanderfolgendes Aufbringen einzelner Schichten erzeugt. Die Schicht b) wird bevorzugt strukturübergreifend ausgebildet und anschließend strukturiert oder durch Aufwachsen auf den gewünschten Strukturen erzeugt. Gegebenenfalls wird das Material der Schicht b) geeignet nachbehandelt; z. B. durch weitere Oxidation oder Ausheizen.

Auf die Schicht b) wird als Schicht c) ein transparenter elektrischer Leiter aufgebracht. Die Schicht c) kann ihrerseits wiederum aus Lagen gleichartiger oder unterschiedlicher transparenter elektrischer Leiter bestehen. Der transparente elektrische Leiter wird durch ein geeignetes Metall (z. B. Pt, Au) und/oder ein transparentes Metalloxid und/oder einen organischen Leiter gebildet. Metallschichten müssen zur Erhaltung der Transparenz entsprechend dünn ausgebildet sein. Zur Ausbildung der metallischen Schichten kommen aus dem Stand der Technik bekannte Verfahren zum Einsatz. Wenn der transparente elektrische Leiter aus einem transparenten Metalloxid besteht, wird vorzugsweise AZO, ITO, ATO oder FTO eingesetzt. Die Schicht eines transparenten elektrischen Leiters wird ebenfalls strukturübergreifend ausgebildet und anschließend strukturiert oder durch Aufwachsen auf den gewünschten Strukturen erzeugt.

Gegebenenfalls wird die Schicht eines transparenten elektrischen Leiters geeignet nachbearbeitet, indem sie beispielsweise mit einer Deck- bzw. Zusatzschicht versehen wird. Bevorzugt bedeckt die Deckschicht die Oberseite der transparenten gleichrichtenden Kontaktstruktur so, dass die Schicht c) zwischen Schicht b) und der zusätzlichen Deckschicht angeordnet ist. Die Deckschicht kann antireflexive Eigenschaften aufweisen und/oder chemisch und/oder elektrisch passivierend wirken. Die Deckschicht wird vorteilhaft aus einem elektrisch nicht leitenden Material (z. B. HfO₂, Al₂O₃, ZrO₂, SiOₓ, Si₃N₄ etc. aber auch organisches Material, z. B. PMMA (Polymethylmethacrylat oder Epoxidharz)) mittels bekannter Verfahren erzeugt. Diese Verfahren sind z. B. Kathodenzerstäubung (Sputtern), spin coating, dip coating, Atomlagenabscheidung (ALD), gepulste Laserdeposition (PLD).

Die erfindungsgemäßen gleichrichtenden Kontaktstrukturen kommen vorteilhaft in elektronischen Bauteilen, wie integrierten Schaltkreisen, Leucht- und Fotodioden, Fototransistoren und ähnlichem zum Einsatz. Die erfindungsgemäßen gleichrichtenden Kontaktstrukturen werden darüber hinaus vorteilhaft in Applikationen aus Optoelektronik, Solartechnik, Sensorik, Signalerfassung, Signal- und Datenverarbeitung sowie bei der Herstellung von Anzeigeelementen, Displays und dergleichen eingesetzt. Insbesondere ein Einsatz der erfindungsgemäßen gleichrichtenden Kontaktstruktur als UV-Fotodetektor ist vorteilhaft.

Die Erfindung wird nachfolgend durch Ausführungsbeispiele näher erläutert, die jedoch nicht als beschränkend anzusehen sind.

### Ausführungsbeispiele

### Ausführungsbeispiel 1: Gleichrichtender, transparenter Au/AgₓO-Kontakt auf heteroepitaktischem ZnO-Dünnfilm

Durch gepulste Laserdeposition (PLD) wird auf einem *a*-Saphir-Substrat eine etwa ein Mikrometer dicke Zinkoxidschicht abgeschieden. Ohne Oberflächenvorbehandlung werden durch reaktives Sputtern von Silber in einer Argon/Sauerstoff-Atmosphäre transparente AgₓO-Punktkontakte (Dicke < 10 nm) aufgebracht, die mit einer transparenten Goldschicht (Dicke < 5 nm) abgedeckt werden.

Diese Kontaktstrukturen wirken als Dioden und können als Gleichrichter und zur Detektion von elektromagnetischer Strahlung (Photodiode) oder adsorbierten Molekülen (chemischer Sensor) verwendet werden.

### Ausführungsbeispiel 2: Kontakt in einem ZnO-basierten, transparenten MESFET (Metall-Halbleiter-Feldeffekttransistor (engl. metal semiconductor field effect transistor, MESFET))

Durch gepulste Laserdeposition (PLD) wird auf einem *a*-Saphir-Substrat eine etwa 20 nm dicke Zinkoxidschicht abgeschieden. Aus dieser Schicht wird durch Ätzen eine Mesa prozessiert. Basierend auf den oben genannten Kontakten wird auf die Mesa durch reaktives Sputtern von Silber ein transparenter AgₓO-Gate-Kontakt aufgebracht. Anschließend wird mittels PLD transparentes, aluminiumdotiertes, hochleitfähiges Zinkoxid als Deckschicht aufgebracht. Die Source- und Drain-Kontakte werden ebenfalls durch PLD von transparentem, aluminiumdotiertem, hochleitfähigem Zinkoxid hergestellt.

Basierend auf diesen MESFETs können volltransparente integrierte Schaltungen (z. B. Inverter, logische Gatter) hergestellt werden. Sie können beispielhaft auch als transparente Schaltelemente für die Pixelsteuerung in Aktiv-Matrix-Flüssigkristall-Anzeigeelementen oder OLED-Displays verwendet werden.

## Patentansprüche

1. Transparente gleichrichtende Kontaktstruktur, die folgende Bestandteile aufweist:
a) einen transparenten Halbleiter, ausgewählt aus der Gruppe weitbandlückiger Halbleiter, die ZnO, Diamant, ZnMgO, CuAlO₂, ZnS, ZnSe, ZnCdO, Ga₂O₃, In₂O₃ und organische Halbleiter enthält,
b) eine transparente, nicht isolierende und nicht leitende Schicht aus Metalloxid, Metallsulfid und/oder Metallnitrid, wobei der spezifische Widerstand der Schicht bevorzugt im Bereich von 10² Ωcm bis 10⁷ Ωcm liegt, und
c) eine Schicht aus einem transparenten elektrischen Leiter wobei die Schicht b) zwischen dem Halbleiter a) und der Schicht c) ausgebildet ist.

2. Transparente gleichrichtende Kontaktstruktur nach Anspruch 1, **dadurch gekennzeichnet, dass** die Schicht b) ein Oxid, Sulfid oder Nitrid eines Metalls ausgewählt aus einer Gruppe, die Ag, Pt, Ir, Cu, Pd, Cr, Ni und andere Metalle enthält, aufweist.

3. Verwendung einer transparenten gleichrichtenden Kontaktstruktur in Applikationen in der Sensorik, wobei die Kontaktstruktur die folgenden Bestandteile aufweist:
a) einen transparenten Halbleiter, ausgewählt aus der Gruppe weitbandlückiger Halbleiter, die ZnO, Diamant, ZnMgO, CuAlO₂, ZnS, ZnSe, ZnCdO, Ga₂O₃, In₂O₃ und organische Halbleiter enthält,
b) eine transparente, nicht isolierende und nicht leitende Schicht aus einem Oxid, Sulfid oder Nitrid eines Metalls ausgewählt aus einer Gruppe, die Ag, Pt, Ir, Cu, Pd, Cr und andere Metalle enthält wobei der spezifische Widerstand der Schicht bevorzugt im Bereich von 10² Ωcm bis 10⁷ Ωcm liegt, und
c) eine Schicht aus einem transparenten elektrischen Leiter wobei die Schicht b) zwischen dem Halbleiter a) und der Schicht c) ausgebildet ist.

4. Transparente gleichrichtende Kontaktstruktur nach Anspruch 1 oder 2 oder Verwendung nach Anspruch 3, **dadurch gekennzeichnet, dass** der Halbleiter a) als Volumenmaterial, als Dünnschicht oder als Nanostruktur ausgebildet ist.

5. Transparente gleichrichtende Kontaktstruktur nach Anspruch 2 oder 4 oder Verwendung nach Anspruch 3 oder 4, **dadurch gekennzeichnet, dass** das Substrat transparent und/oder flexibel ist.

6. Transparente gleichrichtende Kontaktstruktur nach einem der Ansprüche 1, 2, 4 oder 5oder Verwendung nach einem der Ansprüche 3 bis 5, **dadurch gekennzeichnet, dass** der Halbleiter a) dotiert und/oder gemischt und/oder legiert ist und/oder Heterostrukturen aufweist.

7. Transparente gleichrichtende Kontaktstruktur nach einem der Ansprüche 1, 2 oder 4 bis 6 oder Verwendung nach einem der Ansprüche 3 bis 6, **dadurch gekennzeichnet, dass** die Schicht b) aus mehreren Schichten besteht.

8. Transparente gleichrichtende Kontaktstruktur nach einem der Ansprüche 1, 2 oder 4 bis 7 oder Verwendung nach einem der Ansprüche 3 bis 7, **dadurch gekennzeichnet, dass** die Schicht b) mehr Metallatome enthält als durch das stöchiometrische Verhältnis vorgegeben ist.

9. Transparente gleichrichtende Kontaktstruktur nach einem der Ansprüche 1, 2 oder 4 bis 8 oder Verwendung nach einem der Ansprüche 3 bis 8, **dadurch gekennzeichnet, dass** die Schicht c) mindestens eines der folgenden Materialien aufweist:
i) ein transparentes leitfähiges Oxid, bevorzugt ausgewählt aus der Gruppe, die Indiumzinnoxid (Indium Tin Oxide ITO), Fluorzinnoxid (Fluor Tin Oxide, FTO), Aluminiumzinkoxid (Aluminium Zinc Oxide, AZO) und Antimonzinnoxid (Antimony Tin Oxide, ATO) enthält, und/oder
ii) ein Metall aus der Gruppe, die Au, Ag, Pt, Cu, In enthält, und/oder
iii) ein organisches leitfähiges Material.

10. Transparente gleichrichtende Kontaktstruktur oder Verwendung nach Anspruch 9, **dadurch gekennzeichnet, dass** die Schicht c) dotiert ist und/oder ein Gemisch ist und/oder legiert ist und/oder aus mehreren Schichten besteht.

11. Transparente gleichrichtende Kontaktstruktur oder Verwendung nach einem der Ansprüche 9 oder 10, **dadurch gekennzeichnet, dass** die Schicht c) ein Metalloxid aufweist und dieses mehr Metallatome enthält, als durch das stöchiometrische Verhältnis vorgegeben ist.

12. Verfahren zur Herstellung einer transparenten gleichrichtenden Kontaktstruktur, dass die folgenden Schritte aufweist:
● Bereitstellen eines transparenten Halbleiters a), ausgewählt aus der Gruppe weitbandlückiger Halbleiter, die ZnO, Diamant, ZnMgO, CuAlO₂, ZnS, ZnSe, ZnCdO, Ga₂O₃, In₂O₃, und organische Halbleiter enthält
● Aufbringen einer transparenten, nicht isolierenden und nicht leitenden Schicht b) eines Metalloxids, Metallsulfids und/oder Metallnitrids, wobei der spezifische Widerstand der Schicht bevorzugt im Bereich von 10² Ωcm bis 10⁷ Ωcm liegt, auf ausgewählten Bereichen des Halbleiters a),
● Aufbringen einer Schicht c) eines transparenten elektrischen Leiters auf den ausgewählten Bereichen des Halbleiters a), wobei die Schicht c) von dem Halbleiter a) durch die Schicht b) getrennt ist.

13. Verfahren zur Herstellung einer transparenten gleichrichtenden Kontaktstruktur zum Einsatz in Applikationen in der Sensorik, wobei das Verfahren die folgenden Schritte aufweist:
● Bereitstellen eines transparenten Halbleiters a), ausgewählt aus der Gruppe weitbandlückiger Halbleiter, die ZnO, Diamant, ZnMgO, CuAlO₂, ZnS, ZnSe, ZnCdO, Ga₂O₃, In₂O₃, und organische Halbleiter enthält
● Aufbringen einer transparenten, nicht isolierenden und nicht leitenden Schicht b) aus einem Oxid, Sulfid oder Nitrid eines Metalls ausgewählt aus einer Gruppe, die Ag, Pt, Ir, Cu, Pd, Cr, und andere Metalle enthält, wobei der spezifische Widerstand der Schicht bevorzugt im Bereich von 10² Ωcm bis 10⁷ Ωcm liegt, auf ausgewählten Bereichen des Halbleiters a),
● Aufbringen einer Schicht c) eines transparenten elektrischen Leiters auf den ausgewählten Bereichen des Halbleiters a), wobei die Schicht c) von dem Halbleiter a) durch die Schicht b) getrennt ist.

14. Verfahren nach Anspruch 12, **dadurch gekennzeichnet, dass** der Halbleiter a) dotiert und/oder auf seiner Oberfläche gereinigt wird.

15. Verfahren nach Anspruch 12 oder 13, **dadurch gekennzeichnet, dass** die Schicht b) durch Oxidation einer Metallschicht oder durch nacheinander folgende Ausbildung mehrerer Schichten desselben oder unterschiedlicher Metalloxide ausgebildet wird.

16. Verfahren nach einem der Ansprüche 12 bis15, **dadurch gekennzeichnet, dass** die Schicht c) eines durch nacheinander folgende Ausbildung mehrerer Schichten desselben oder unterschiedlicher transparenter elektrischer Leiter ausgebildet wird.

17. Verwendung einer transparenten gleichrichtenden Kontaktstruktur nach einem der Ansprüche 1 bis 11 in der Optoelektronik, Solartechnik, Sensorik, Signalerfassung, Signal- und Datenverarbeitung, in Anzeigeelementen, Displays und integrierten Schaltungen.

## Claims

1. Transparent rectifying contact structure comprising the following components:
a) a transparent semiconductor, selected from the group of wide band gap semiconductors, the group containing ZnO, diamond, ZnMgO, CuAlO₂, ZnS, ZnSe, ZnCdO, Ga₂O₃, In₂O₃ and organic semiconductors,
b) a transparent non-insulating and non-conducting layer of metal oxide, metal sulfide and/or metal nitride, wherein the specific resistivity of the layer is preferably in the range of 10² Ωcm to 10⁷ Ωcm, and
c) a layer of a transparent electrical conductor,
wherein the layer b) is formed between the semiconductor a) and the layer c).

2. Transparent rectifying contact structure according to claim 1, **characterized in that** the layer b) comprises an oxide, sulfide, or nitride of a metal selected from a group containing Ag, Pt, Ir, Cu, Pd, Cr, Ni and other metals.

3. Use of a transparent rectifying contact structure in applications in sensor technology, wherein the contact structure comprises the following components:
a) a transparent semiconductor, selected from the group of wide band gap semiconductors, the group containing ZnO, diamond, ZnMgO, CuAlO₂, ZnS, ZnSe, ZnCdO, Ga₂O₃, In₂O₃ and organic semiconductors,
b) a transparent non-insulating and non-conducting layer of an oxide, sulfide or nitride of a metal selected from a group containing Ag, Pt, Ir, Cu, Pd, Cr and other metals, wherein the specific resistivity of the layer is preferably in the range of 10² Ωcm to 10⁷ Ωcm, and
c) a layer of a transparent electrical conductor,
wherein the layer b) is formed between the semiconductor a) and the layer c).

4. Transparent rectifying contact structure according to claim 1 or 2 or use according to claim 3, **characterized in that** the semiconductor a) is in the form of a volume material, a thin layer or a nanostructure.

5. Transparent rectifying contact structure according to claim 2 or 4 or use according to claim 3 or 4, **characterized in that** the substrate is transparent and/or flexible.

6. Transparent rectifying contact structure according to one of claims 1, 2, 4 or 5 or use according to one of the claims 3 to 5, **characterized in that** the semiconductor a) is doped and/or mixed and/or alloyed and/or has heterostructures.

7. Transparent rectifying contact structure according to one of the claims 1, 2, or 4 to 6 or use according to one of the claims 3 to 6, **characterized in that** the layer b) is comprised of several layers.

8. Transparent rectifying contact structure according to one of the claims 1, 2 or 4 to 7 or use according to one of the claims 3 to 7, **characterized in that** the layer b) contains more metal atoms than is predetermined by the stoichiometric ratio.

9. Transparent rectifying contact structure according to one of the claims 1, 2 or 4 to 8 or use according to one of the claims 3 to 8, **characterized in that** the layer c) comprises at least one of the following materials:
i) a transparent conductive oxide, preferably selected from the group that contains indium tin oxide (ITO), fluorine tin oxide (FTO), aluminum zinc oxide (AZO), and antimony tin oxide (ATO) and/or
ii) a metal of the group that contains Au, Ag, Pt, Cu, In, and/or
iii) an organic conductive material.

10. Transparent rectifying contact structure or use according to claim 9, **characterized in that** the layer c) is doped and/or a mixture and/or is alloyed and/or is comprised of several layers.

11. Transparent rectifying contact structure or use according to one of the claims 9 or 10, **characterized in that** the layer c) comprises a metal oxide and the latter contains more metal atoms than is predetermined by the stoichiometric ratio.

12. Method for producing a transparent rectifying contact structure comprising the following steps:
- providing a transparent semiconductor a) selected from the group of wide band gap semiconductors, the group containing ZnO, diamond, ZnMgO, CuAlO₂, ZnS, ZnSe, ZnCdO, Ga₂O₃, In₂O₃ and organic semiconductors,
- applying a transparent non-insulating and non-conducting layer b) of a metal oxide, metal sulfide and/or metal nitride onto selected areas of the semiconductor a), wherein the specific resistivity of the layer is preferably in the range of 10² Ωcm to 10⁷ Ωcm,
- applying a layer c) of a transparent electrical conductor onto the select areas of the semiconductor a), wherein the layer c) is separated from the semiconductor a) by the layer b).

13. Method for producing a transparent rectifying contact structure for use in applications in sensor technology, wherein the method comprises the following steps:
- providing a transparent semiconductor a), selected from the group of wide band gap semiconductors, the group containing ZnO, diamond, ZnMgO, CuAlO₂, ZnS, ZnSe, ZnCdO, Ga₂O₃, In₂O₃ and organic semiconductors,
- applying a transparent non-insulating and non-conducting layer b) of an oxide, sulfide or nitride of a metal selected from a group containing Ag, Pt, Ir, Cu, Pd, Cr and other metals onto select areas of the semiconductor a), wherein the specific resistivity of the layer is preferably in the range of 10² Ωcm to 10⁷ Ωcm,
- applying a layer c) of a transparent electrical conductor onto the select areas of the semiconductor a), wherein the layer c) is separated from the semiconductor a) by the layer b).

14. Method according to claim 12, **characterized in that** the semiconductor a) is doped and/or is purified on its surface.

15. Method according to claim 12 or 13, **characterized in that** the layer b) is formed by oxidation of a metal layer or by sequential formation of several layers of the same or different metal oxides.

16. Method according to one of the claims 12 to 15, **characterized in that** the layer c) is formed by sequential formation of several layers of the same or different transparent electrical conductors.

17. Use of a transparent rectifying contact structure according to one of the claims 1 to 11 in optoelectronics, solar technology, sensor technology, signal detection, signal processing and data processing, in display elements, displays, and integrated circuits.

## Revendications

1. Structure de contact de redressement transparente, qui présente les composants suivants :
a) un semi-conducteur transparent sélectionné dans le groupe des semi-conducteurs à large bande de trous qui contiennent ZnO, du diamant, ZnMgO, CuAlO₂, ZnS, ZnSe, ZnCdO, Ga₂O₃, In₂O₃, et des semi-conducteurs organiques,
b) une couche transparente, non isolante et non conductrice, en oxyde métallique, sulfure métallique et/ou nitrure métallique, où la résistance spécifique de la couche est de préférence comprise dans la gamme de 10² Ωcm à 10⁷ Ωcm, et
c) une couche d'un conducteur électrique transparent,
où la couche b) est formée entre le semi-conducteur a) et la couche c).

2. Structure de contact de redressement transparente selon la revendication 1, **caractérisée en ce que** la couche b) présente un oxyde, un sulfure ou un nitrure d'un métal sélectionné dans le groupe qui contient Ag, Pt, Ir, Cu, Pd, Cr, Ni et d'autres métaux.

3. Utilisation d'une structure de contact de redressement transparente dans des applications d'analyse sensorielle, où la structure de contact présente les éléments suivants :
a) un semi-conducteur transparent sélectionné dans le groupe des semi-conducteurs à large bande de trous qui contiennent ZnO, du diamant, ZnMgO, CuAlO₂, ZnS, ZnSe, ZnCdO, Ga₂O₃, In₂O₃, et des semi-conducteurs organiques,
b) une couche transparente, non isolante et non conductrice, en oxyde, sulfure et/ou nitrure d'un métal sélectionné dans un groupe qui contient Ag, Pt, Ir, Cu, Pd, Cr et d'autres métaux, où la résistance spécifique de la couche est de préférence comprise dans la gamme de 10² Ωcm à 10⁷ Ωcm, et
c) une couche d'un conducteur électrique transparent,
où la couche b) est formée entre le semi-conducteur a) et la couche c).

4. Structure de contact de redressement transparente selon la revendication 1 ou 2 ou utilisation selon la revendication 3, **caractérisée en ce que** le semi-conducteur a) est exécuté en tant que matériau volumique, en tant que couche mince ou en tant que nanostructure.

5. Structure de contact de redressement transparente selon la revendication 2 ou 4 ou utilisation selon la revendication 3 ou 4, **caractérisée en ce que** le substrat est transparent et/ou flexible.

6. Structure de contact de redressement transparente selon l'une des revendications 1, 2, 4 ou 5, ou utilisation selon l'une des revendications 3 à 5, **caractérisée en ce que** le semi-conducteur a) est dopé et/ou est composite et/ou est allié et/ou présente des hétérostructures.

7. Structure de contact de redressement transparente selon l'une des revendications 1, 2 ou 4 à 6, ou utilisation selon l'une des revendications 3 à 6, **caractérisée en ce que** la couche b) se compose de plusieurs couches.

8. Structure de contact de redressement transparente selon l'une des revendications 1, 2 ou 4 à 7, ou utilisation selon l'une des revendications 3 à 7, **caractérisée en ce que** la couche b) contient plus d'atomes métalliques que ce qui est donné ou prévu par le rapport stoechiométrique.

9. Structure de contact de redressement transparente selon l'une des revendications 1, 2 ou 4 à 8, ou utilisation selon l'une des revendications 3 à 8, **caractérisée en ce que** la couche c) présente au moins l'un des matériaux suivants :
i) un oxyde conducteur transparent, sélectionné de préférence dans le groupe qui contient l'oxyde d'indium-étain (ITO), l'oxyde de fluor-étain (FTO), l'oxyde d'aluminium-zinc (AZO) et l'oxyde d'antimoine-étain (ATO), et/ou
ii) un métal du groupe qui contient Au, Ag, Pt, Cu, In, et/ou
iii) un matériau organique conducteur.

10. Structure de contact de redressement transparente ou utilisation selon la revendication 9, **caractérisée en ce que** la couche c) est dopée et/ou est un composite et/ou est alliée et/ou se compose de plusieurs couches.

11. Structure de contact de redressement transparente ou utilisation selon l'une des revendications 9 ou 10, **caractérisée en ce que** la couche c) présente un oxyde métallique et **en ce que** celui-ci contient plus d'atomes métalliques que ce qui est donné ou prévu par le rapport stoechiométrique.

12. Procédé de fabrication d'une structure de contact de redressement transparente, qui comprend les étapes suivantes :
- mise à disposition d'un semi-conducteur transparent a), sélectionné dans le groupe des semi-conducteurs à large bande de trous qui contiennent ZnO, du diamant, ZnMgO, CuAlO₂, ZnS, ZnSe, ZnCdO, Ga₂O₃, In₂O₃, et des semi-conducteurs organiques,
- application d'une couche transparente, non isolante et non conductrice b) d'un oxyde métallique, d'un sulfure métallique et/ou d'un nitrure métallique, où la résistance spécifique de la couche est de préférence comprise dans la gamme de 10² Ωcm à 10⁷ Ωcm, sur des zones sélectionnées du semi-conducteur a),
- application d'une couche c) d'un conducteur électrique transparent sur les zones sélectionnées du semi-conducteur a), où la couche c) est séparée du semi-conducteur a) par la couche b).

13. Procédé de fabrication d'une structure de contact de redressement transparente destinée à une utilisation dans des applications d'analyse sensorielle, où le procédé comprend les étapes suivantes :
- mise à disposition d'un semi-conducteur transparent a) sélectionné dans le groupe des semi-conducteurs à large bande de trous qui contiennent ZnO, du diamant, ZnMgO, CuAlO₂, ZnS, ZnSe, ZnCdO, Ga₂O₃, In₂O₃, et des semi-conducteurs organiques,
- application d'une couche transparente, non isolante et non conductrice b) d'un oxyde, d'un sulfure ou d'un nitrure d'un métal sélectionné dans un groupe qui contient Ag, Pt, Ir, Cu, Pd, Cr et d'autres métaux, où la résistance spécifique de la couche est de préférence comprise dans la gamme de 10² Ωcm à 10⁷ Ωcm, sur des zones sélectionnées du semi-conducteur a),
- application d'une couche c) d'un conducteur électrique transparent sur les zones sélectionnées du semi-conducteur a), où la couche c) est séparée du semi-conducteur a) par la couche b).

14. Procédé selon la revendication 12, **caractérisé en ce que** le semi-conducteur a) est dopé et/ou est nettoyé ou purifié sur sa surface.

15. Procédé selon la revendication 12 ou 13, **caractérisé en ce que** la couche b) est formée par oxydation d'une couche métallique ou par formation successive de plusieurs couches de celui-ci ou de différents oxydes métalliques.

16. Procédé selon l'une des revendications 12 à 15, **caractérisé en ce que** la couche c) est formée d'un conducteur par formation successive de plusieurs couches de celui-ci ou de différents conducteurs électriques transparents.

17. Utilisation d'une structure de contact de redressement transparente selon l'une des revendications 1 à 11 en optoélectronique, technique solaire, analyse sensorielle, détection de signal, traitement des signaux et des données, dans des éléments d'affichage, des écrans et des circuits intégrés.
